Europäisches Patentamt

European Patent Office

Office européen des brevets

(11) Numéro de publication: **0 192 511**
**B1**

# (12) FASCICULE DE BREVET EUROPEEN

(45) Date de publication du fascicule du brevet:
08.11.89

(21) Numéro de dépôt: 86400105.2

(22) Date de dépôt: 20.01.86

(51) Int. Cl.⁴: **H 01 L 21/28**, H 01 L 21/31, H 01 L 27/02

(54) Procédé d'obtention d'une diode dont la prise de contact est auto-alignée à une grille.

(30) Priorité: 25.01.85 FR 8501085

(43) Date de publication de la demande:
27.08.86 Bulletin 86/35

(45) Mention de la délivrance du brevet:
08.11.89 Bulletin 89/45

(84) Etats contractants désignés:
DE GB NL

(56) Documents cités:
EP-A- 0 051 534
FR-A- 2 464 561
US-A- 4 247 861

IEEE ELECTRON DEVICE LETTERS, vol. EDL-3, no. 2, février 1982, pages 40-42, IEEE, New York, US; S. HSIA et al.: "Polysilicon oxidation self-aligned MOS (POSA MOS) - a new self-aligned double source/drain ion implantation technique for VLSI"
IBM TECHNICAL DISCLOSURE BULLETIN, vol. 22, no. 8B, janvier 1980, pages 3688-3691, New York, US; R.C. VARSHNEY: "Polysilicon oxide process for small line gaps"
IEDM INTERNATIONAL ELECTRON DEVICES MEETING, Washington, DC, 8-10 décembre 1980, Technical Digest, papier 6.3, pages 140-143, IEEE, New York, US; H.S. FU et al.: "A new MOS transistor design with self-registering source-drain and gate contacts"

(73) Titulaire: THOMSON-CSF, 51, Esplanade du Général de Gaulle, F-92800 Puteaux (FR)

(72) Inventeur: Blanchard, Pierre, THOMSON-CSF SCPI 19, avenue de Messine, F-75008 Paris (FR)

(74) Mandataire: Lincot, Georges et al, THOMSON-CSF SCPI, F-92045 PARIS LA DEFENSE CEDEX 67 (FR)

## Description

La présente invention concerne un procédé d'obtention d'une diode dont la prise de contact est auto-alignée à une grille.

L'invention s'applique notamment à la réalisation des prises de contact au niveau des jonctions de drains ou de sources des transistors unipolaires connus sous la désignation MOS qui est l'abréviation de «Metal Oxyde Semiconducteur» et à celles des éléments photosensibles des matrices de transfert de ligne.

Il est connu pour réaliser une diode de faible dimension avec prise de contact adjacente à une ou plusieurs grilles, isolées de la diode par des matériaux isolants, d'opérer selon un procédé photolithographique consistant à créer successivement sur une couche diélectrique recouvrant un substrat semi-conducteur, d'abord une photo-grille puis une photo-diode alignée sur la photo-grille et enfin un photo-contact isolé de la grille. Selon ce procédé la diode est autopositionnée par rapport à la grille, mais la prise de contact doit être effectuée après l'oxydation qui succède à l'implantation de diffusion des impuretés qui forment la jonction de la diode, de ce fait il n'est plus possible de positionner de façon précise la zone de contact par rapport à la grille, il existe donc un risque de courtcircuit entre la diode et la grille, par l'intermédiaire de la métallisation.

Le but de l'invention est de pallier les inconvénients précités.

A cet effet l'invention a pour objet, un procédé d'obtention d'une diode dont la prise de contact est auto-alignée à une grille, le procédé consistant à déposer sur un substrat semi-conducteur au moins une première couche d'un matériau diélectrique, à déposer sur la dernière couche de diélectrique une couche de silicium polycristallin pour former la grille, puis une deuxième couche de silicium polycristallin au-dessus de la structure résultante, à graver dans les couches de silicium polycristallin l'emplacement de la diode contact jusqu'à la mise à nue de la couche diélectrique, à oxyder la deuxième couche de silicium polycristallin et la partie mise à nue de la première couche de silicium polycristallin de manière suffisante pour qu'une couche d'oxyde recouvre entièrement le reste de la première couche de silicium formant la grille et ne recouvre que partiellement la partie mise à nue de la couche diélectrique et à doper la partie du substrat non recouverte par la couche d'oxyde pour former la jonction de la diode.

Le procédé selon l'invention a principalement pour avantage qu'il permet de réaliser un contact d'interconnexion avec une diode, de mêmes dimensions que celle-ci et auto-aligné par rapport à une grille par le fait que la diode, le contact et une partie de la grille sont réalisés avec le même niveau de masquage. Le procédé selon l'invention a aussi pour avantage de supprimer une photolithographie ce qui permet d'améliorer la compacité des produits réalisés. Il permet également de diminuer la profondeur de la jonction dela diode, celle-ci pouvant être formée juste avant la métalisation aluminium des prises de contact. D'autre part le procédé selon l'invention supprime les risques de mise en court-circuit des grilles avec les éléments limitrophes.

D'autres caractéristiques et avantages de l'invention apparaîtront au cours de la description qui suit faite au regard des dessins annexés dans lesquels:
– les figures 1A, 1B et 1C représentent les phases d'un procédé d'obtention d'une diode contact selon l'art connu;
– les figures 2A à 2D représentent les phases du procédé d'obtention d'une diode contact selon l'invention;
– les figures 3A et 3B représentent deux modes de réalisation d'éléments photosensibles obtenus respectivement à partir du procédé représenté aux figures 1A à 1C et du procédé selon l'invention représenté aux figures 2A à 2D;
– les figures 4A et 4B représentent une ouverture de contact obtenue en application du procédé selon l'invention;
– la figure 5 est une représentation par contraste avec le dessin de la figure 4B d'une ouverture de contact obtenue à l'aide des procédés photolithographiques habituels;
– les figures 6A à 6D illustrent un premier mode de réalisation d'un transistor MOS réalisé à l'aide du procédé selon l'invention, les diodes étant formées dans la phase finale du procédé;
– les figures 7A à 7E illustrent un deuxième mode de réalisation selon lequel les diodes sont formées avant la formation de l'oxyde d'isolement lié aux connexions;
– les figures 8A à 8E illustrent un troisième mode de réalisation de diodes contact en conservant la double couche de nitrure-oxyde.

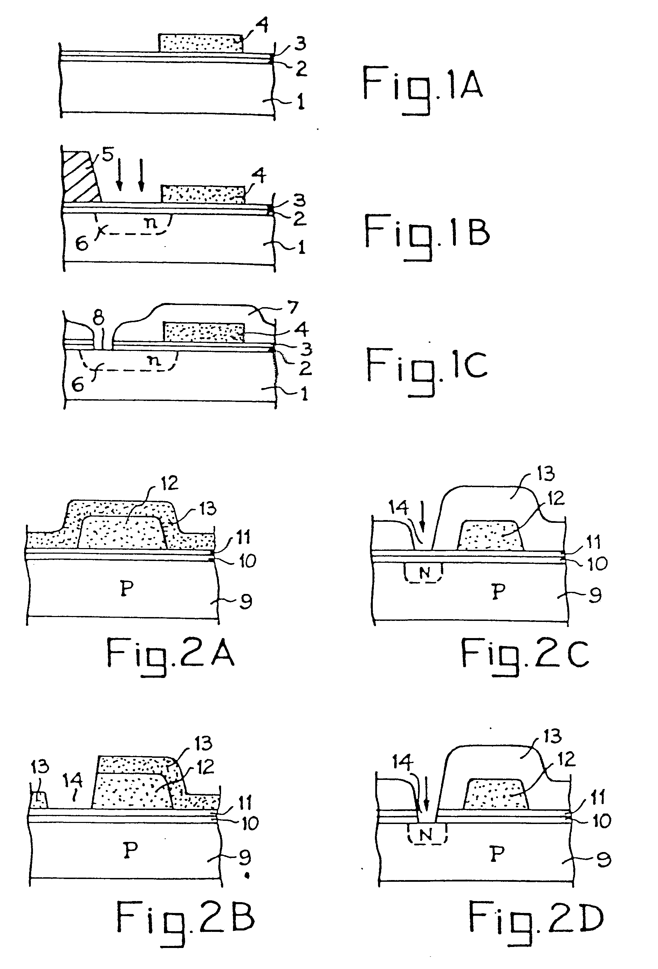

Dans le procédé illustré à l'aide des figures 1A, 1B et 1C qui représentent les phases d'obtention d'une diode contact suivant un procédé de photolitographie de l'art connu, une photo-grille est d'abord réalisée de la façon représentée à la figure 1A en déposant sur un substrat 1 semi-conducteur une première couche de silice 2, puis une deuxième couche de nitrure de silicium 3 au-dessus de la couche de silice 2, et enfin à former une grille par une photolitographie sur une couche de silicium conductrice 4. La photo-diode est formée ensuite, de la manière représentée à la figure 1B, par implantation ionique dans une zone 6 du substrat 1, autoalignée avec la grille 4 au travers d'un masque 5. Le photo-contact est ensuite formé à l'étape représentée à la figure 1C par dépôt d'une couche d'oxyde 7 autour de la couche de silicium 4 formant grille puis par attaque de la couche de nitrure 3 et désoxydation de la couche de silice 2 pour permettre d'accéder au substrat 1 et former l'ouverture de contact 8. En se reportant à la figure 1C il est apparent que le procédé qui vient d'être décrit ne permet pas de positionner l'ouverture de contact 8 par rapport à la grille 4 avec suffisamment de précision pour éliminer tout risque de court-circuit entre le contact qui sera par la suite formé dans l'ouverture 8 d'accès à la diode 6 et la grille 4.

Le procédé selon l'invention qui est décrit ci-après à l'aide des figures 2A à 2D, permet de remédier à cet inconvénient. Il consiste, dans une première étape représentée à la figure 2A, à déposer sur un substrat de silicium 9 une première couche 10 de silice puis une deuxième couche de nitrure de silicium 11 au-dessus de la première couche de silice 10 puis à former par photolitogravure sur un premier dépôt de silicium polycristallin 12 la grille à réaliser, puis à recouvrir la première couche de silicium 12 par une deuxième couche de silicium polycristallin 13. A l'étape suivante, représentée à la figure 2B, les couches de silicium polycristallin 12 et 13 sont gravées pour mettre à nue la couche de nitrure de silicium 11 à l'intérieur d'une fenêtre 14 pratiquée à l'endroit où la diode doit être formée. Puis, à l'étape représentée à la figure 2C, la couche de silicium 13 est oxydée pour isoler la grille formée par la couche de silicium polycristallin 12. Enfin, à l'étape représentée à la figure 2D, la couche de nitrure de silicium 11 et la couche de silice 10 sont attaquées pour mettre à nue la face supérieure du substrat dans la fenêtre 14 pratiquée par la gravure précédente, et la diode est formée à l'intérieur de la fenêtre 14 par implantation ionique ou par diffusion d'impuretés dans le substrat 9 à l'intérieur de la fenêtre 14 ce qui a l'avantage de permettre de pratiquer un temps de tirage minimum des impuretés implantées ou diffusées et permet d'obtenir une profondeur de jonction plus faible. On notera, que le mode de réalisation qui vient d'être décrit n'est pas unique et que, selon une variante d'exécution du procédé selon l'invention, la diode pourra être formée à l'étape représentée à la figure 2C après gravure de la couche de silicium 13 par implantation à travers la double couche de silice 10 et de nitrure de silicium 11. Dans l'une ou l'autre variante de réalisation, le procédé selon l'invention permet d'obtenir un contact d'interconnexion de la diode de mêmes dimensions que la diode elle-même, ce qui améliore la compacité des produits obtenus et rend possible dans le premier cas la diminution de la profondeur de jonction de la diode qui peut être formée juste avant l'opération de métalisation, par l'aluminium, par exemple, des prises de contact. Ces caractéristiques de l'invention permettent de l'appliquer très efficacement à la construction, soit d'éléments photosensibles de matrices à transfert de ligne, soit à la réalisation de prises de contact de sources et de drains de transistors MOS.

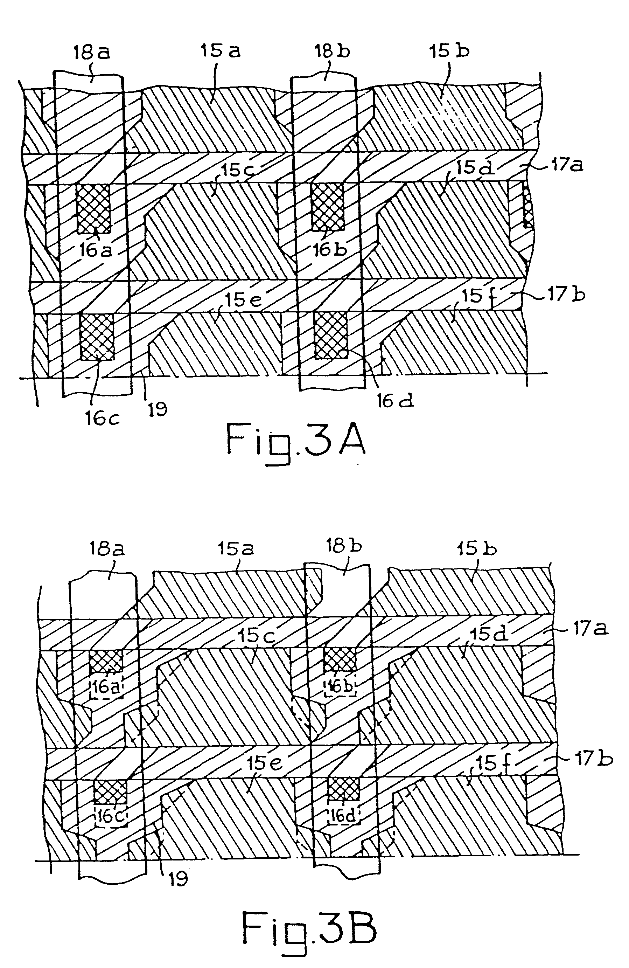

Un exemple de réalisation d'éléments photosensibles d'une matrice à transfert de ligne est décrit ci-après à l'aide de schémas représentés aux figures 3A et 3B. La figure 3A représente une matrice à transfert de ligne possédant des diodes avec prises de contacts obtenues suivant le procédé de l'art connu décrit précédemment à l'aide des figures 1A et 1B. La matrice représentée se compose de quatre parties, une première partie est formée par un ensemble de diodes de stockage 15a à 15f représentant des éléments de surface photosensible, une deuxième partie est formée par un ensemble de diodes de lecture 16a à 16d, une troisième partie est formée par des grilles 17a à 17b pour commander le passage des charges électriques entre les diodes de stockage et les diodes de lecture, et une quatrième partie est formée par les lignes d'interconnexion 18a 18b reliées aux diodes de lecture pour transférer par exemple, les charges lues vers une barrette CCD de lecture extérieure. Dans cette configuration les lignes d'interconnexion sont perpendiculaires aux grilles de commande du passage des charges et un oxyde épais 19 isole les surfaces photosensibles 15a à 15f des diodes de lecture 16a à16d.

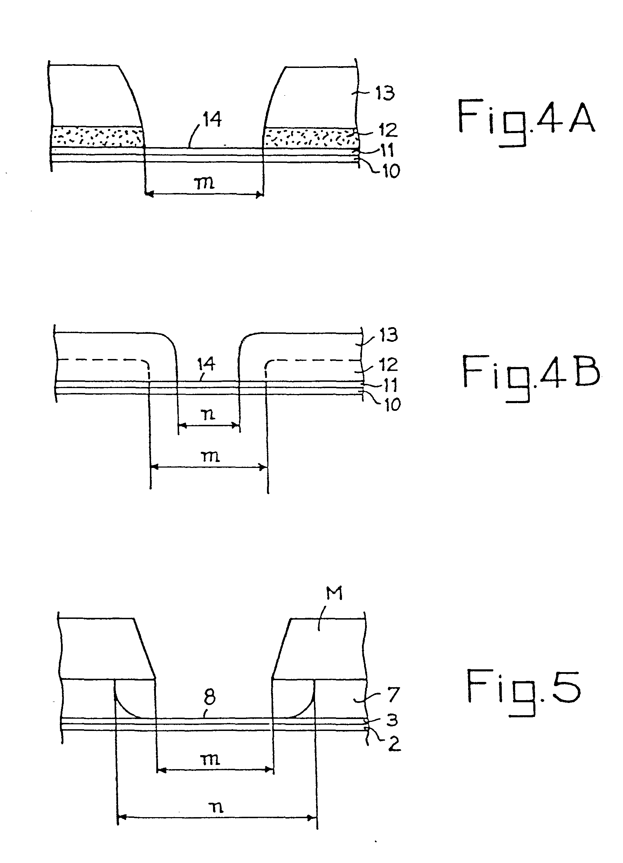

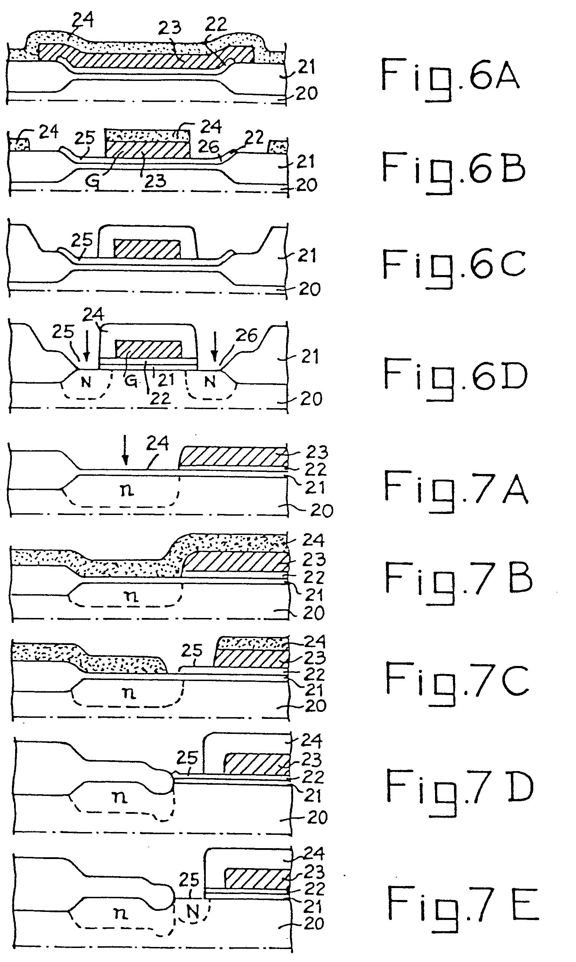

Le procédé selon l'invention appliqué à la fabrication des matrices à transfert de ligne, du type de celle qui vient d'être décrite à l'aide de la figure 3A, permet de privilégier les surfaces de stockage pour augmenter la sensibilité de chacun des éléments de stockage 15a à15f. En diminuant la surface occupée par chacune des diodes de lecture 16a à 16d il devient possible, de la façon représentée à la figure 3B, d'augmenter la surface de chacune des diodes de stockage 15a à 15f en auto-alignant chacune des diodes de lecture 16a à16d sur leurs grilles de passage respectives 17a et 17b et en contrôlant l'ouverture de contact pratiquée au-dessus de chaque diode 16a à 16d. Contrairement au procédé connu décrit précédemment à l'aide des figures 1A à1C, le procédé selon l'invention permet d'exercer un contrôle des dimensions de l'ouverture de contact en fonction de l'épaisseur de la couche de silicium 13 utilisée. Sur les ouvertures de contact représentées par exemple aux figures 4A et 4B, la cote de contact n qui est obtenue, dépend d'une part, de la cote nominale m de la fenêtre pratiquée dans la couche de silicium 12 et d'autre part, de l'épaisseur de l'oxyde formé 13. En fait, en revenant à la figure 3B, on constate que plus l'épaisseur de l'oxyde formé 13 est importante, plus les dimensions de l'ouverture de contact des diodes 16a à 16d diminuent et plus il est possible d'augmenter la surface photosensible des diodes de stockage 15a à 15f. Ce résultat va à l'encontre des résultats obtenus par les procédés traditionnels, car en revenant à la figure 1C l'ouverture de contact dans un processus habituel consiste à attaquer la couche isolante d'oxyde de silicium 7 au travers d'un masque M ce qui a pour résultat l'obtention d'une ouverture n représentée à la figure 5 qui ne peut qu'augmenter en fonction de l'épaisseur de la couche d'oxyde 7 réalisée par rapport à l'ouverture m pratiquée dans le masque M.

La réalisation de prises de contact source drain de transistor MOS à l'aide du procédé selon l'invention peut être obtenue, soit en formant les diodes contact du transistor MOS à la fin du processus d'obtention du transistor, soit en formant les diodes avant le deuxième dépôt de silicium. Dans le premier cas, représenté aux figures 6A à 6D, on procède comme à la figure 2A par un dépôt sur un substrat semi-conducteur 20 d'une première couche de silice 21 suivie d'une deuxième couche de nitrure de silicium 22 et on dépose au-dessus de la couche de nitrure de silicium 22 une première couche de silicium 23, puis une deuxième couche de silicium 24, cette dernière étant ensuite transformée en oxyde pour former l'isolant de la grille. Les couches de silicium 23 et 24 sont gravées de la façon représentée à la figure 6B pour former, la grille G du transistor et deux fenêtres 25 et 26 situées de part et d'autre de la grille G. Après croissance d'oxyde au-dessus de la couche de silicium 23 de la grille G (figure 6C) la couche de nitrure de silicium 22 et la couche mince d'oxyde de silicium 21 sont retirées pour permettre l'accès au substrat 20 pour procéder à une implantation ionique du substrat 20 au travers des fenêtres 25 et 26.

Dans le deuxième cas, représenté aux figures 7A à 7E, les diodes sont formées avant la formation de l'oxyde d'isolement grille-connexion. L'auto-alignement est alors possible en protégeant le nitrure de silicium par un excès dans la grille de la future zone de contact. La couche de silicium 23 formant la grille est tout d'abord recouverte d'une couche de silicium d'apport 24 (figure 7B) puis le silicium d'apport et la couche de silicium formant la grille sont gravées pour former la fenêtre 25 (figure 7C) et faire apparaître la couche de nitrure de silicium 22 (figure 7D) pour ne pas avoir de discontinuités entre la diode et la zone de contact qui sera par la suite dopée (figure 7E).

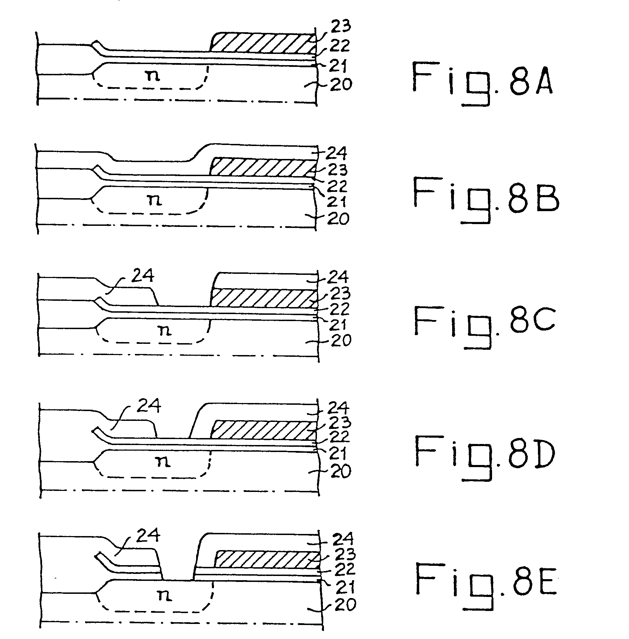

Le procédé selon l'invention est également applicable à la fabrication de diodes réalisées en gardant la double couche nitrure-oxyde, selon les étapes de procédé représenté aux figures 8A à 8E. Selon ce procédé, après implantation (figure 8A) de la diode à travers la double couche de silice 21 et de nitrure de silicium 22, le silicium d'apport 24 est déposé au-dessus de la couche de silicium 23 (figure 8B), puis le silicium d'apport est gravé à la façon représentée à la figure 8C, l'auto-alignement peut alors être réalisé en gravant le silicium de la grille en même temps que la couche de silicium d'apport et après la phase d'oxydation représentée à la figure 8D, la jonction est accédée en attaquant la couche de nitrure de silicium 22 et la couche d'oxyde mince 21.

**Revendications**

1. Procédé d'obtention d'une diode dont la prise de contact est auto-alignée à une grille, le procédé constituant à déposer sur un substrat semi-conducteur (9) au moins une première couche d'un matériau diélectrique (10, 11), à déposer sur la dernière couche diélectrique (11) une première couche de silicium polycristallin (12) pour former la grille, puis une deuxième couche de silicium polycristallin (13) au-dessus de la structure résultante à graver dans les couches de silicium polycristallin (12, 13) l'emplacement de la diode contact jusqu'à la mise à nue de la couche diélectrique (10, 11), à oxyder la deuxième couche de silicium polycristallin (13) et la partie mise à nue de la première couche de silicium polycristallin de manière suffisante pour qu'une couche d'oxyde recouvre entièrement le reste de la première couche de silicium polycristallin (13) formant la grille et ne recouvre que partiellement la partie mise à nue de la couche diélectrique (10, 11), et à doper la partie du substrat (14) non recouverte par la couche d'oxyde pour former la jonction de la diode.

2. Procédé selon la revendication 1, caractérisé en ce que la couche de matériau diélectrique se compose d'une première couche de silice (10) et d'une deuxième couche de nitrure de silicium (11), la première couche de silice (10) étant interposée entre la deuxième couche de nitrure de silicium (11) et le substrat (9).

3. Procédé selon les revendications 1 et 2, caractérisé en ce que le dopage du substrat (9) a lieu par implantation ionique à travers la couche de matériau diélectrique (10, 11).

4. Procédé selon la revendication 2, caractérisé en ce qu'il consiste à mettre à nue la partie (14) du substrat (9) non recouverte par la couche d'oxyde en supprimant la couche diélectrique (10, 11) recouvrant cette partie avant l'opération de dopage pour former la diode.

5. Procédé selon la revendication 4, caractérisé en ce que le dopage de la diode dans le substrat (9) a lieu par un procédé de diffusion d'impuretés dans le substrat.

6. Procédé selon la revendication 4, caractérisé en ce que le dopage de la diode dans le substrat (9) a lieu par implantation ionique d'ions dans le substrat.

7. Utilisation du procédé selon l'une quelconque des revendications 1 à 6 pour la réalisation d'une matrice à transfert de ligne.

8. Utilisation du procédé selon l'une quelconque des revendications 1 à 6 pour la réalisation de transistors MOS.

9. Utilisation du procédé selon l'une quelconque des revendications 1 à 6, pour toute prise de contact auto-alignée et isolée à une ou plusieurs grilles adjacentes.

**Patentansprüche**

1. Verfahren zur Herstellung einer Diode, deren Kontaktanschluß mit einem Gate selbstausgerichtet ist, welches darin besteht, auf einem Halbleiter-Substrat (9) wenigstens eine erste Schicht aus einem dielektrischen Material (10, 11) aufzubringen, auf der letzten dielektrischen Schicht (11) eine erste Schicht aus polykristallinem Silizium (12), um das Gate zu bilden, und dann eine zweite Schicht aus polykristallinem Silizium (13) über der resultierenden Struktur aufzubringen, in den Schichten aus polykristallinem Silizium (12, 13) die Stelle der Kontaktdiode einzugravieren, bis die dielektrische Schicht (10, 11) bloßgelegt wird, die zweite Schicht (13) aus polykristallinem Silizium sowie den bloßgelegten Teil der ersten Schicht aus polykristallinem Silizium ausreichend zu oxidieren, so daß eine Oxid-Schicht den Rest der ersten Schicht (13) aus polykristallinem Silizium, der das Gate bildet, vollständig abdeckt und den bloßgelegten Teil der dielektrischen Schicht (10, 11) nur teilweise abdeckt, und den Teil des Substrats (14), der von der Oxid-Schicht nicht bedeckt ist, zu dotieren, um den Übergang der Diode zu bilden.

2. Verfahren nach Anspruch 1, dadurch gekennzeichnet, daß die Schicht aus dielektrischem Material aus einer ersten Schicht aus Siliziumoxid (10) und aus einer zweiten Schicht aus Siliziumnitrid (11) besteht, wobei die erste Schicht aus Siliziumoxid (10) zwischen der zweiten Schicht aus Siliziumnitrid (11) und dem Substrat (9) eingefügt ist.

3. Verfahren nach den Ansprüchen 1 und 2, dadurch gekennzeichnet, daß die Dotierung des Substrats (9) durch Ionenimplantation durch die Schicht aus dielektrischem Material (10, 11) hindurch erfolgt.

4. Verfahren nach Anspruch 2, dadurch gekennzeichnet, daß es darin besteht, den Teil (14) des Substrats (9), der von der Oxidschicht nicht abgedeckt ist, bloßzulegen, indem man die diesen Teil abdeckende dielektrische Schicht (10, 11) vor dem Dotiervorgang beseitigt, um die Diode zu bilden.

5. Verfahren nach Anspuch 4, dadurch gekennzeichnet, daß das Dotieren der Diode in dem Substrat (9) durch ein Verfahren zum Eindiffundieren von Verunreinigungen in das Substrat erfolgt.

6. Verfahren nach Anspruch 4, dadurch gekennzeichnet, daß das Dotieren der Diode in dem Substrat (9) durch eine Ionenimplantation in dem Substrat erfolgt.

7. Verwendung des Verfahrens nach einem der Ansprüche 1 bis 6 für die Herstellung einer Zeilen-übertragungs-Matrix.

8. Verwendung des Verfahrens nach einem der Ansprüche 1 bis 6 für die Herstellung von MOS-Transistoren.

9. Verwendung des Verfahrens nach einem der Ansprüche 1 bis 6 für jeden isolierten und selbstausgerichteten Kontaktanschluß mit einem oder mehreren benachbarten Gates.

## Claims

1. A method of producing a diode whose contact terminal is self-aligned with a gate, said method consisting in depositing, on a semiconductor substrate (9), at least a first layer of dielectric material (10 and 11), in depositing on the last dielectric layer (11) a first layer of polycrystalline silicon (12) to form the gate, then a second layer of polycrystalline silicon (13) over the resulting structure, in etching the silicon polycrystalline layers (12 and 13) to produce the site of the contact diode to such an extent as to expose the dielectric layer (10 and 11), in oxidizing the second layer of polycrystalline silicon (13) and the exposed part of the first layer of polycrystalline silicon in a sufficient manner to cause an oxide layer to entirely cover the rest of the first layer of polycrystalline silicon (13) forming the gate while only partly covering the exposed part of the dielectric layer (10 and 11), and in doping the part of the substrate (14) which is not covered by the oxide layer in order to form the junction of the diode.

2. The method as claimed in claim 1, characterized in that the layer of dielectric material is made up of a first layer of silicon oxide (10) and a second layer of silicon nitride (11), the first layer of silicon oxide (10) being placed between the second layer of silicon nitride (11) and the substrate (9).

3. The method as claimed in claims 1 and 2, characterized in that the doping of the substrate (9) takes place by ion implantation through the layer of dielectric material (10 and 11).

4. The method as claimed in claim 2, characterized in that it consists in exposing the part (14) of the substrate (9) which is not covered by the oxide layer while eliminating the dielectric layer (10 and 11) covering this part prior to the operation of doping in order to form the diode.

5. The method as claimed in claim 4, characterized in that the doping of the diode in the substrate (9) takes place by a method involving the diffusion of impurities into the substrate.

6. The method as claimed in claim 4, characterized in that the doping of the diode in the substrate (9) takes place by ion implantation into the substrate.

7. The use of the method as claimed in any one preceding claim 1 through 6 in order to produce a line transfer matrix.

8. The use of the method as claimed in any one of the claims 1 through 6 in order to produce MOS transistors.

9. The use of the method as claimed in any one of the claims 1 through 6 for any self-aligned insulated terminal contact at one or more adjacent gates.

Fig.1A

Fig.1B

Fig.1C

Fig.2A

Fig.2B

Fig.2C

Fig.2D

Fig.3A

Fig.3B

Fig.4A

14 — 13
— 12
— 11
— 10

m

Fig.4B

13
14 — 12
— 11
— 10

n

m

Fig.5

M

8 — 7
— 3
— 2

m

n

Fig.6A

Fig.6B

Fig.6C

Fig.6D

Fig.7A

Fig.7B

Fig.7C

Fig.7D

Fig.7E

Fig.8A

Fig.8B

Fig.8C

Fig.8D

Fig.8E